Europäisches Patentamt

(19) **European Patent Office**

**Office européen des brevets**

(11) Numéro de publication : **0 001 942**
**B1**

(12) **FASCICULE DE BREVET EUROPÉEN**

(45) Date de publication du fascicule du brevet :
**29.07.81**

(51) Int. Cl.³ : **C 01 B 33/00**, C 23 C 11/06,
H 01 L 31/18

(21) Numéro de dépôt : **78400139.8**

(22) Date de dépôt : **19.10.78**

(54) **Procédé de fabrication de silicium pour la conversion photovoltaïque.**

(30) Priorité : **04.11.77 FR 7733170**

(43) Date de publication de la demande :
**16.05.79 (Bulletin 79/10)**

(45) Mention de la délivrance du brevet :
**29.07.81 Bulletin 81/30**

(84) Etats contractants désignés :
**BE CH DE FR GB NL**

(56) Documents cités :
**DE - B - 1 544 305**
**JOURNAL OF APPLIED PHYSICS,**
**Vol. 48, n° 9, September 1977**
**Nijmegen, Netherlands**
**N. W. M. GRAEF et al. : "Enhanced crystallinity of silicon films deposited by CVD on liquid layers (CVDOLL process) : Silicon on tin layers in the presence of hydrogen chloride" pages 3 937-3 940, colonne 2.**

(73) Titulaire : **RHONE-POULENC INDUSTRIES**
**22, avenue Montaigne**
**F-75008 Paris (FR)**

(72) Inventeur : **Anglerot, Didier**
**17, rue Labois-Rouillon**
**F-75019 - Paris (FR)**

(74) Mandataire : **Savina, Jacques et al**
**RHONE POULENC Service Brevets Chimie et Polymères B.P. 753**
**F-75360 Paris Cedex 08 (FR)**

Imprimerie Jouve, 17, rue du Louvre, 75001 Paris, France

## Procédé de fabrication de silicium pour la conversion photovoltaïque

La présente invention a pour objet un procédé de fabrication de silicium pour la conversion photovoltaïque et concerne plus particulièrement la préparation de silicium polycristallin en couche mince par réduction d'un composé du silicium.

La préparation de silicium très pur par réduction de tétrachlorure de silicium par le zinc à l'état vapeur est connue (Lyon, Olson et Lewis Trans. Electrochem. Soc. *96* (1949) 359). Cette réaction a lieu à 950 °C, les cristaux obtenus ont la forme d'aiguilles. Ce procédé présente les inconvénients de nécessiter l'utilisation d'une température de réaction élevée, d'être difficile à mettre en œuvre du fait de l'existence de zinc à l'état de vapeur qui entraîne la nécessité d'utiliser un rebouilleur, et de ne pas être directement exploitable, le silicium obtenu sous forme d'aiguilles devant être refondu au-dessus de 1 400 °C pour être utilisable.

La demanderesse a découvert un procédé de fabrication de silicium qui obvie aux inconvénients précités et qui présente notamment les avantages d'être utilisable à une température en général voisine de 750 °C, d'être aisé à mettre en œuvre et de permettre une exploitation facile pour la fabrication de photopiles, le silicium pouvant être directement recueilli sous forme d'une couche polycristalline sur un substrat éventuellement conducteur.

La présente invention concerne, en effet, un procédé de fabrication de silicium polycristallin en couche mince par réduction d'un composé du silicium à l'état gazeux par le zinc, caractérisé en ce que l'on met en œuvre le zinc à l'état liquide et au moins un métal à l'état liquide choisi parmi le groupe comprenant : l'étain, le plomb, l'or, l'argent, l'antimoine, le bismuth, les conditions opératoires étant choisies telles que le composé du zinc formé lors de la réaction soit à l'état gazeux.

Dans la suite de la description, on désignera par « M » l'un au moins des métaux : étain, plomb, or, argent, antimoine, bismuth.

Le composé du silicium mis en œuvre selon l'invention peut être tout composé du silicium étant à l'état gazeux dans les conditions de la réduction et qui permet la formation d'un composé du zinc, également à l'état gazeux, dans ces conditions. Selon une mise en œuvre particulière de l'invention, on utilisera les halogénosilanes et, de préférence, le tétrachlorosilane car ce dernier, facilement accessible sur le plan industriel, peut, par ailleurs, être aisément purifié par des méthodes conventionnelles.

Le composé du silicium est introduit à l'état gazeux dans le milieu réactionnel, il peut être mis en œuvre à l'état pur ou éventuellement dilué dans un gaz pur et anhydre. Parmi ces gaz, on peut citer notamment l'azote, l'argon, l'hydrogène ou des mélanges de ceux-ci, le gaz diluant ne devant pas réduire le composé du silicium dans les conditions de la réaction et devant conserver au milieu son caractère réducteur. Le rapport en volume de gaz diluant par rapport au composé du silicium peut varier dans de larges limites, pratiquement des rapports variant de 0 à 1 000 conviennent, on mettra en œuvre de préférence des rapports variant de 0,5 à 5.

La pression partielle du composé du silicium n'est pas un facteur critique selon l'invention, elle peut varier dans de larges limites, pratiquement une pression partielle comprise entre $10^{-3}$ atmosphère et 1 atmosphère convient aux fins de l'invention.

Le zinc et M sont mis en œuvre selon l'invention à l'état liquide. Ils peuvent être introduits dans le milieu réactionnel séparément ou simultanément.

Selon une variante de l'invention, le zinc peut éventuellement être remplacé en partie par un métal liquide dans les conditions de l'invention. Ce métal doit réduire le composé du silicium, ne pas former de siliciures et former, lors de la réaction avec le composé du silicium, un composé à l'état gazeux. Les métaux répondant à ces conditions sont notamment l'aluminium, le gallium et l'indium.

La proportion en poids de zinc mise en œuvre selon l'invention par rapport à M peut varier dans de larges limites ; elle est cependant de préférence inférieure à 15 % et généralement comprise entre 1 et 10 %.

Bien que cela ne soit pas clairement établi, selon la demanderesse il est permis de penser que M assure une double fonction, d'une part il abaisse la tension de vapeur du zinc dans le milieu, donc évite la tendance à une perte du réducteur, d'autre part et éventuellement en association avec le zinc mis en œuvre selon l'invention, il sert de substrat de cristallisation au silicium formé lors de la réduction.

Si M représente plusieurs des métaux selon l'invention, il est nécessaire que ceux-ci soient en proportion telle que M soit liquide dans les conditions de la réaction.

Selon une variante de l'invention, il peut être envisagé d'effectuer la réaction sur un support solide mouillé par la phase liquide et dont les éléments ne diffusent pas dans la couche de silicium.

Les conditions opératoires du procédé selon l'invention doivent être telles que le composé du silicium soit à l'état gazeux, que le zinc et M soient à l'état liquide et que le composé du zinc, formé lors de la réaction, soit à l'état gazeux. Une température comprise entre 500 et 907 °C et, de préférence, de 700 et 800 °C ainsi qu'une pression totale comprise entre $10^{-3}$ et 1 atmosphère et, de préférence, d'une atmosphère conviennent aux fins de l'invention. De plus, il est nécessaire d'éviter la présence de toute trace d'humidité ou d'oxygène dans le milieu réactionnel.

Après refroidissement, le silicium est obtenu sous forme d'une mince couche polycristalline sur le substrat métallique M.

La mince couche de silicium polycristallin obtenue ne présente qu'un seul grain dans l'épaisseur, cette caractéristique permet notamment l'application du procédé selon l'invention à la fabrication de silicium pour la conversion photovoltaïque. La taille des cristaux obtenus peut atteindre un millimètre ; généralement pour l'application à la conversion photovoltaïque, l'épaisseur préférée de la couche varie entre 50 et 300 microns.

La présente invention va maintenant être illustrée par l'exemple suivant, donné à titre non limitatif.

Exemple

Dans un réacteur, on a introduit 60 g d'un alliage zinc-étain à 10 % en poids de zinc que l'on chauffe à 750 °C. On introduit alors dans le réacteur un courant gazeux constitué d'un mélange tétrachlorosilane-argon à 75 % en volume d'argon à un débit de 15 litres par heure. La pression partielle de tétrachlorosilane est maintenue à la valeur de 190 mm Hg (25 331 Pa) et la pression totale à 760 mm Hg (101 325 Pa). Le chlorure de zinc gazeux formé au cours de la réaction est éliminé par le balayage du courant argon-tétrachlorosilane.

Après 3 heures, on arrête le courant gazeux et l'on purge le réacteur avec de l'argon. Après refroidissement, on recueille une couche d'environ 200 $\mu$ de silicium polycristallisé sur une matrice d'étain.

**Revendications**

1. Procédé de fabrication de silicium polycristallin en couche mince par réduction d'un composé du silicium à l'état gazeux par le zinc, caractérisé en ce que l'on met en œuvre le zinc à l'état liquide et au moins un métal à l'état liquide choisi parmi le groupe comprenant : l'étain, le plomb, l'or, l'argent, l'antimoine, le bismuth, les conditions opératoires étant choisies telles que le composé du zinc formé lors de la réduction soit à l'état gazeux.

2. Procédé selon la revendication 1, caractérisé en ce que le composé du silicium est un halogénosilane.

3. Procédé selon la revendication 2, caractérisé en ce que le composé du silicium est le tétrachlorosilane.

4. Procédé selon l'une quelconque des revendications 1, 2, 3, caractérisé en ce que le composé du silicium est mis en œuvre à l'état pur ou dilué dans un gaz choisi parmi le groupe comprenant : l'azote, l'argon, l'hydrogène ou des mélanges de ceux-ci.

5. Procédé selon la revendication 4, caractérisé en ce que le rapport en volume de gaz diluant par rapport au composé du silicium est compris entre 0 et 1 000.

6. Procédé selon la revendication 5, caractérisé en ce que le rapport est compris entre 0,5 et 5.

7. Procédé selon l'une quelconque des revendications précédentes, caractérisé en ce que la pression partielle du composé du silicium est comprise entre $10^{-3}$ et 1 atmosphère.

8. Procédé selon l'une quelconque des revendications précédentes, caractérisé en ce que la proportion en poids de zinc mise en œuvre par rapport au métal M est inférieure à 15 %.

9. Procédé selon la revendication 8, caractérisé en ce que cette proportion est comprise entre 1 et 10 %.

10. Procédé selon l'une quelconque des revendications précédentes, caractérisé en ce que la température de la réaction est comprise entre 500 et 907 °C et la pression totale entre $10^{-3}$ et 1 atmosphère.

11. Procédé selon la revendication 10, caractérisé en ce que la température est comprise entre 700 et 800 °C et la pression totale est de 1 atmosphère.

12. Procédé selon la revendication 1, caractérisé en ce que le zinc est remplacé en partie par au moins un métal choisi parmi le groupe comprenant l'aluminium, le gallium et l'indium.

13. Procédé selon la revendication 1, caractérisé en ce que la réaction de réduction est effectuée sur un support solide mouillé par la phase liquide et dont les éléments ne diffusent pas dans la couche de silicium.

14. Application du silicium obtenu selon le procédé de l'une quelconque des revendications 1 à 13 à la conversion photovoltaïque.

**Claims**

1. Process for the manufacture of a thin layer of polycrystalline silicon by reducing a silicon compound, in the gaseous state, with zinc, characterised in that zinc, in the liquid state, and at least one metal, in the liquid state, chosen from amongst the group comprising : tin, lead, gold, silver, antimony and bismuth, are used, the operating conditions being chosen so that the zinc compound formed during the reduction is in the gaseous state.

2. Process according to Claim 1, characterised in that the silicon compound is a halogenosilane.

3. Process according to Claim 2, characterised in that the silicon compound is tetrachlorosilane.

4. Process according to any one of Claims 1, 2 and 3, characterised in that the silicon compound is used in the pure state or diluted in a gas chosen from amongst the group comprising : nitrogen, argon, hydrogen or mixtures of these.

5. Process according to Claim 4, characterised in that the volume ratio of diluent gas to the silicon compound is between 0 and 1 000.

6. Process according to Claim 5, characterised in that the ratio is between 0,5 and 5.

7. Process according to any one of the preceding claims, characterised in that the partial pressure of the silicon compound is between $10^{-3}$ and 1 atmosphere.

8. Process according to any one of the preceding claims, characterised in that the proportion by weight of zinc used is less than 15 %, relative to the metal M.

9. Process according to Claim 8, characterised in that this proportion is between 1 and 10 %.

10. Process according to any one of the preceding claims, characterised in that the reaction temperature is between 500 and 907 °C and the total pressure is between $10^{-3}$ and 1 atmosphere.

11. Process according to Claim 10, characterised in that the temperature is between 700 and 800 °C and the total pressure is 1 atmosphere.

12. Process according to Claim 1, characterised in that the zinc is partially replaced by at least one metal chosen from amongst the group comprising aluminium, gallium and indium.

13. Process according to Claim 1, characterised in that the reduction reaction is carried out on a solid support which is wetted by the liquid phase, and the constituents of which do not diffuse into the silicon layer.

14. Application of the silicon obtained in accordance with the process of any one of Claims 1 to 13 to photovoltaic conversion.

**Ansprüche**

1. Verfahren zur Herstellung von polykristallinem Silizium in einer dünnen Schicht durch Reduktion einer Siliziumverbindung in gasförmigem Zustand durch Zink, dadurch gekennzeichnet, daß man das Zink und mindestens ein Metall aus der Gruppe Zinn, Blei, Gold, Silber, Antimon und Wismuth in flüssigem Zustand einsetzt und die Verarbeitungsbedingungen derart wählt, daß die bei der Reduzierung gebildete Zinkverbindung in gasförmigem Zustand ist.

2. Verfahren nach Anspruch 1, dadurch gekennzeichnet, daß die Siliziumverbindung ein Halogensilan ist.

3. Verfahren nach Anspruch 2, dadurch gekennzeichnet, daß die Siliziumverbindung Tetrachlorsilan ist.

4. Verfahren nach irgendeinem der Ansprüche 1 bis 3, dadurch gekennzeichnet, daß die Siliziumverbindung in reinem Zustand oder verdünnt mit einem Gas aus der Gruppe Stickstoff, Argon und Wasserstoff oder Gemische davon eingesetzt wird.

5. Verfahren nach Anspruch 4, dadurch gekennzeichnet, daß das Volumenverhältnis des verdünnenden Gases zur Siliziumverbindung zwischen 0 und 1 000 liegt.

6. Verfahren nach Anspruch 5, dadurch gekennzeichnet, daß das Verhältnis zwischen 0,5 und 5 beträgt.

7. Verfahren nach irgendeinem der Ansprüche 1 bis 6, dadurch gekennzeichnet, daß der Partialdruck der Siliziumverbindung zwischen $10^{-3}$ und 1 Atmosphären gewählt ist.

8. Verfahren nach irgendeinem der Ansprüche 1 bis 7, dadurch gekennzeichnet, daß der Gewichtsanteil des eingesetzten Zinks im Verhältnis zum Metall M unter 15 % liegt.

9. Verfahren nach Anspruch 8, dadurch gekennzeichnet, daß dieser Gewichtsanteil zwischen 1 und 10 % liegt.

10. Verfahren nach irgendeinem der Ansprüche 1 bis 9, dadurch gekennzeichnet, daß die Reaktionstemperatur zwischen 500 und 907 °C und der Gesamtdruck zwischen $10^{-3}$ und 1 Atmosphären beträgt.

11. Verfahren nach Anspruch 10, dadurch gekennzeichnet, daß die Temperatur zwischen 700 und 800 °C liegt und der Gesamtdruck eine Atmosphäre beträgt.

12. Verfahren nach Anspruch 1, dadurch gekennzeichnet, daß das Zink teilweise durch mindestens ein Metall aus der Gruppe Aluminium, Gallium und Indium ersetzt ist.

13. Verfahren nach Anspruch 1, dadurch gekennzeichnet, daß die Reduktionsreaktion auf einem festen durch die flüssige Phase befeuchteten Träger durchgeführt wird, dessen Elemente nicht in die Siliziumschicht diffundieren.

14. Verwendung des nach dem Verfahren gemäß irgendeinem der Ansprüche 1 bis 13 hergestellten Siliziums zu Zwecken der photoelektrischen Umwandlung.